# EUROPEAN PATENT SPECIFICATION

(11) **EP 1 727 181 B1**
(45) Date of publication and mention of the grant of the patent: **19.08.2009**
(21) Application number: 06114634.6
(22) Date of filing: 29.05.2006
(51) Int. Cl.: H01J 17/49, H01J 17/16

(54) **Plasma display apparatus**
Plasmaanzeigevorrichtung
Appareil d'affichage à plasma

(30) Priority: 28.05.2005 KR 20050045300
(43) Date of publication of application: 29.11.2006
(73) Proprietor: Samsung SDI Co., Ltd., Suwon-si Gyeonggi-do (KR)
(72) Inventor: SHIN, Dong-Hyok, Yeongtong-gu, Suwon-si Gyeongg-do (KR)
(74) Representative: Hengelhaupt, Jürgen

(56) References cited:
- WO-A-96/07303
- DE-A1- 4 344 863
- US-A1- 2005 067 956

## Description

### BACKGROUND OF THE INVENTION

### 1. Field of the Invention

The present invention relates to a plasma display apparatus, and more particularly, to a plasma display apparatus including bosses with improved structure disposed on a chassis base.

### 2. Description of the Related Technology

Plasma display apparatuses are flat panel display apparatuses displaying images using a gas discharge phenomenon, and are considered to be a replacement for conventional cathode ray tubes (CRTs) since they have good image quality, are thin and light weight, have a wide viewing angle, and provide a large screen.

A plasma display apparatus generally includes a plasma display panel, a printed circuit board driving the plasma display panel, a chassis base disposed between the plasma display panel and the printed circuit board to support the plasma display panel and the printed circuit board, and a case accommodating the plasma display panel, the printed circuit board and the chassis base.

Such a plasma display apparatus is disclosed in document US 2005/0067956.

In such a plasma display apparatus, the printed circuit board can be mounted on the chassis base while being separated a predetermined distance from the chassis base. Therefore, the chassis base includes bosses protruding toward the printed circuit board, and each of the bosses includes a screw recess. In addition, coupling holes corresponding to the bosses are formed in the printed circuit board. Bolts are inserted into the coupling holes and bolted into the screw recesses of the bosses to couple the printed circuit board to the chassis base.

As described above, the bolts are used to install the printed circuit board on the chassis base, and various kinds of bolts having different standards can be used. The structures of the bosses are required to be changed according to the bolts, and thus, costs for manufacturing multiple boss sizes and installing the bosses on the chassis base rise.

### SUMMARY OF CERTAIN INVENTIVE ASPECTS

The present invention provides a plasma display apparatus according to claim 1 and including bosses that are common to various sizes of bolts, and thus, costs for manufacturing the plasma display apparatus can be reduced.

The boss is common to various kinds of bolts.

The bolt coupled to the boss may include a head portion, and a screw portion extending from the head portion and coupling to the first screw recess.

The bolt coupled to the boss may include a head portion, and a screw portion extending from the head portion and coupling to the second screw recess.

The bolt coupled to the bosses may include a head portion, a screw portion extending from the head portion and coupling to the first screw recess, and a guide portion extending from the screw portion and inserted into the second screw recess of the boss.

The guide portion may include a screw that is coupled to the second screw recess of the boss.

The boss may further include an inclined connection portion between the first screw recess and the second screw recess.

The boss may be forcibly inserted into the chassis base to be coupled with the chassis base.

The boss may correspond to the printed circuit board to fix the printed circuit board on the chassis base.

### BRIEF DESCRIPTION OF THE DRAWINGS

Embodiments of the present invention will be described with reference to the attached drawings.

FIG. 1 is an exploded perspective view of a plasma display apparatus according to an embodiment of the present invention.

FIG. 2 is an exploded perspective view of bosses that are disposed on a chassis base to correspond to a printed circuit board in the plasma display apparatus of FIG. 1.

FIG. 3 is an exploded perspective view of coupling a kind of bolt to the boss of FIG. 2.

FIG. 4 is a cross-sectional view of a status where the bolt of FIG. 3 is coupled to the boss.

FIG. 5 is an exploded perspective view of coupling a different kind of bolt to the boss shown in FIG. 3.

FIG. 6 is a cross-sectional view of a status where the bolt of FIG. 5 is coupled to the boss.

FIG. 7 is an exploded perspective view of coupling a different kind of bolt to the boss of FIG. 3.

FIG. 8 is a cross-sectional view of the status where the bolt of FIG. 7 is coupled to the boss.

### DETAILED DESCRIPTION OF CERTAIN INVENTIVE EMBODIMENTS

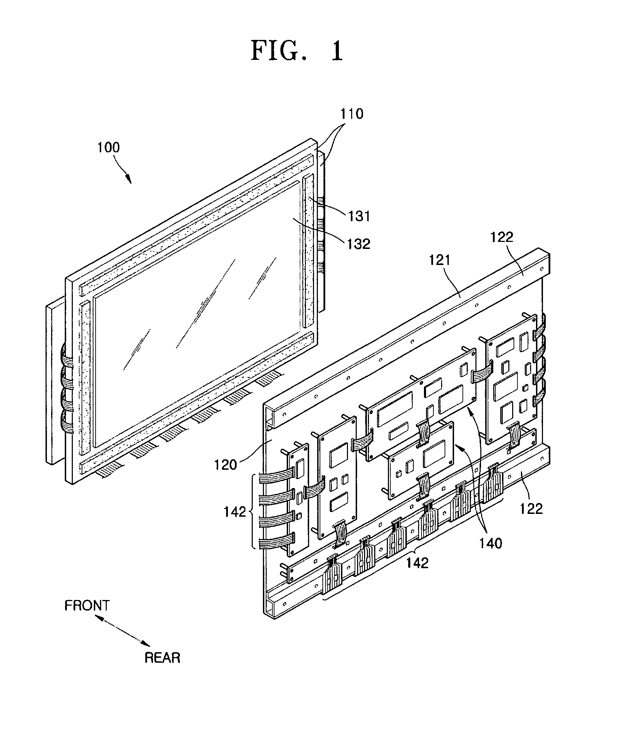

FIG. 1 is an exploded perspective view of a plasma display apparatus according to an embodiment of the present invention.

In one embodiment, the plasma display apparatus 100 includes a plasma display panel 110, a chassis base 120, and at least one printed circuit board 140.

The plasma display panel 110 displays images using a gas discharge. The plasma display panel 110 can be, for example, an alternating current (AC) plasma display panel having a surface discharge type three-electrode structure.

In this case, the plasma display panel includes a front panel and a rear panel facing the front panel. The front panel includes a front substrate, pairs of sustain electrodes formed on a rear surface of the front substrate, each pair of sustain electrodes including a common electrode and a scan electrode that are separated by a discharge gap, a front dielectric layer covering the sustain electrodes, and a protective layer formed on the first dielectric layer (all not shown). In addition, the rear panel coupled to the front panel includes a rear substrate, address electrodes formed on a front surface of the rear substrate and extending perpendicular to the sustain electrodes, a rear dielectric layer covering the address electrodes, barrier ribs formed on the rear dielectric layer to define discharge cells, and phosphor layers disposed in the discharge cells (all not shown). The discharge cells correspond to regions where the sustain electrode pairs and the address electrodes intersect each other, and a discharge gas is filled in the discharge cells.

The chassis base 120 is disposed behind the plasma display panel 110. In one embodiment, the chassis base 120 can be formed of various materials such as aluminum or plastic, and has a size corresponding to that of the plasma display panel 110 to support the plasma display panel 110. The chassis base 120 dissipates heat generated by the plasma display panel 110. The chassis base 120 may include bending portions 121 that are bent backward on edges of the chassis base 120 and prevent the chassis base 120 from being bent or warped. In addition, reinforcing members 122 may be installed on the rear surface of the chassis base 120. The reinforcing members 122 may be formed of a metal material, and coupled to the rear surface of the chassis base 120 in order to prevent the chassis base 120 from being bent or distorted. In addition, the reinforcing members 122 increase a heat dissipation area of the chassis base 120, thereby improving a heat dissipation efficiency.

In one embodiment, an adhesive member 131 such as a dual-adhesive tape couples the chassis base 120 to the plasma display panel 110. In one embodiment, a thermal conductive medium 132 is disposed between the chassis base 120 and the plasma display panel 110 to dissipate the heat generated by the plasma display panel 110 to the environment.

In one embodiment, the at least one printed circuit board 140 is installed on a rear portion of the chassis base 120 to drive the plasma display panel 110. Referring to FIG. 1, the printed circuit boards 140 are electrically connected to each other, and each of the printed circuit boards 140 includes various electronic devices 141 for driving the plasma display panel 110. The printed circuit boards 140 may include a power board receiving electric power and converting the power, a logic board receiving an image signal input from the outside and converting the signal into a signal suitable for the operating type of the plasma display panel, and a buffer board temporarily storing the data processed by the logic board.

In one embodiment, signal transmitting members 142 transmit electric signals produced by the printed circuit boards 140 to the plasma display panel 110. The signal transmitting members 142 may be at least one of flexible printed cables (FPCs), tape carrier packages (TCPs), and chips on film (COFs). In one embodiment, the printed circuit boards 140 are accommodated in a case (not shown) with the plasma display panel 110 and the chassis base 120, thereby forming the plasma display apparatus 100.

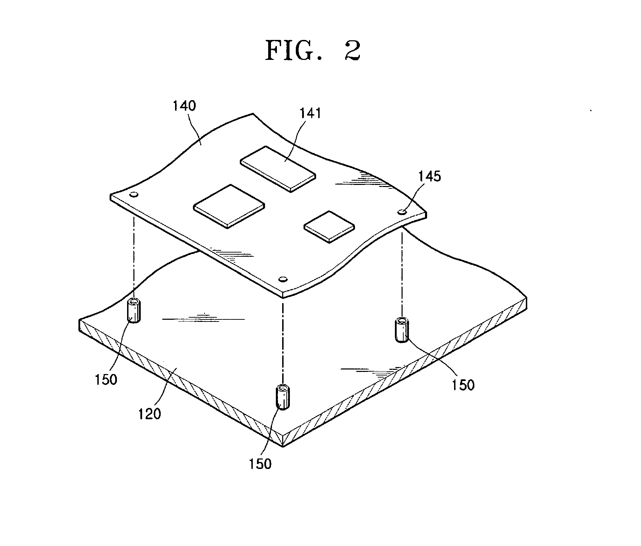

In one embodiment, a plurality of bosses 150 are formed on the chassis base 120 in order to install a plurality of members such as the printed circuit boards 140 on the chassis base 120. In one embodiment, as shown in FIG. 2, the bosses 150 are formed on the rear surface of the chassis base 120 so that the printed circuit boards 140 can be installed on the chassis base 120. In one embodiment, the bosses 120 are disposed on the chassis base 120 to correspond to corners of the printed circuit board 140, and protrude a predetermined height from the rear surface of the chassis base 120 toward the printed circuit board 140. Accordingly, the printed circuit boards 140 can be separated from the chassis base 120, and thus, influences of the printed circuit boards 140 and the chassis base 120 on each other can be reduced.

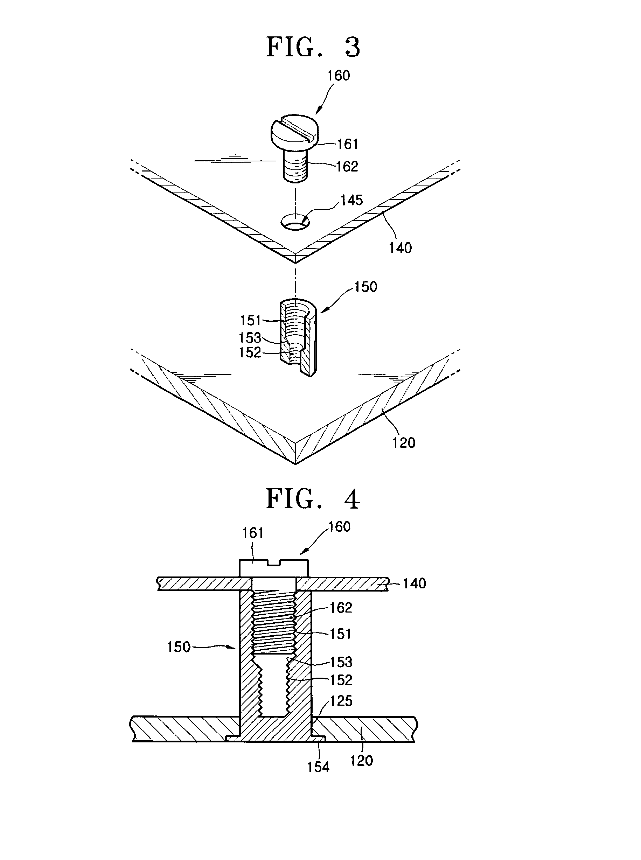

In one embodiment, the bosses 150 are fabricated separately from the chassis base 120, and then coupled to the chassis base 120. For example, referring to FIG. 4, the bosses can be forcibly inserted into the chassis base 120 to be coupled with the chassis base 120, and in this case, the chassis base 120 includes penetration holes 125 into which the bosses 150 can be inserted. In one embodiment, a rim 154 is formed around an outer circumference on an end portion of each boss 150 inserted into the chassis base 120. In this embodiment, when the boss 150 is inserted into the penetration hole 125 formed on the chassis base 120, the rim 154 is forcibly inserted into a recessed region around the penetration hole 125. Alternatively, the boss 150 can be integrally manufactured with the chassis base 120.

In one embodiment, the bosses 150 protruding from the rear surface of the chassis base 120 have a common structure so that various kinds of bolts 160, 170, and 180 can be selected and coupled with the bosses 150.

In one embodiment, as shown in FIGS. 3 and 4, each of the bosses 150 includes a first screw recess 151 and a second screw recess 152 formed sequentially from the protruding end portion of the boss 150. The second screw recess 152 has a smaller inner diameter than the first screw recess 151. In one embodiment, the first and second screw recesses 151 and 152 are fabricated by forming female screw in recesses.

In one embodiment, a connection portion 153 connecting the first screw recess 151 and the second screw recess 152 does not include the female screw, and is inclined. In this embodiment, the connection portion 153 guides an end portion of the bolt when the bolt is sufficiently long for at least a portion of the bolt to be inserted into the second screw recess 152. In another embodiment, the connection portion 153 may not be inclined so that it can be processed easily. However, the connection portion may be inclined for convenient connection with bolts.

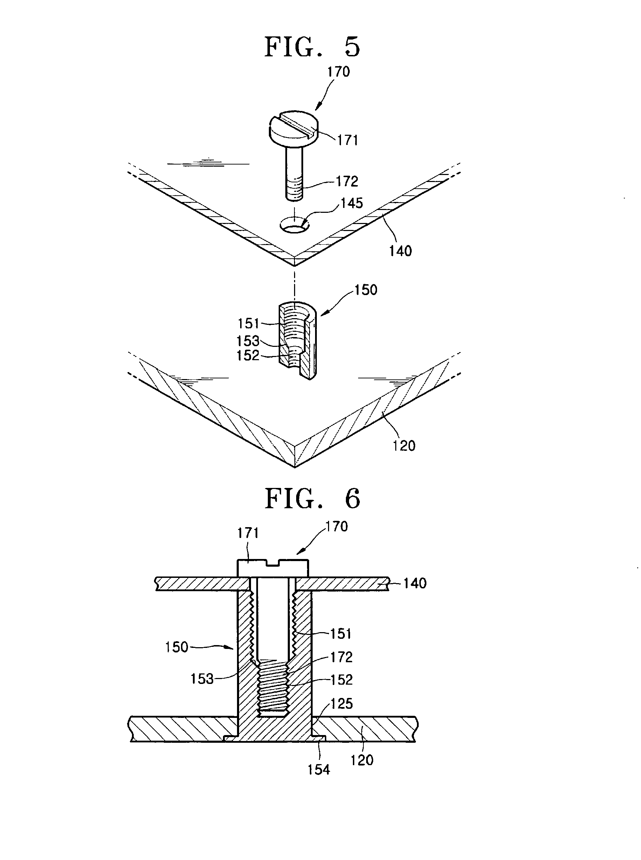

In one embodiment, at least two kinds of bolts 160 and 170 having different diameters from each other can be coupled with the boss 150 of the above structure. That is, the bolt 160 illustrated in FIGS. 3 and 4 can be coupled with the first screw recess 151 of the boss 150, and the bolt 170 illustrated in FIGS. 5 and 6 can be coupled with the second screw recess 152 of the boss 150. In another embodiment, three or more types of bolts having different diameters from each other can be coupled with the boss 150. In this embodiment, the boss 150 would have three screw portions being different in their diameter.

In one embodiment, the bolt 160 illustrated in FIGS. 3 and 4 is coupled with the first screw recess 151 of the boss 150 through a coupling hole 145 of the printed circuit board 140 to fix the printed circuit board 140. In this embodiment, the bolt 160 includes a head portion 161 having a greater diameter than the coupling hole 145 of the printed circuit board 140, and a screw portion 162 that has an outer diameter which corresponds to the inner diameter of the first screw recess 151, extends from the head portion 161. In one embodiment, as shown in FIG. 4, a lower end of the screw portion 162 may be separated a predetermined distance from the lower end of the first screw recess 151 when the bolt 160 is completely bolted into the boss 150 so that the head portion 161 can be adhered around the coupling hole 145 of the printed circuit board 140. In another embodiment, a lower end of the screw portion 162 may be aligned with the lower end of the first screw recess 151 (i.e., no predetermined distance existing) when the bolt 160 is completely bolted into the boss 150.

In another embodiment, as shown in FIGS. 5 and 6, the bolt 170 is coupled with the second screw recess 152 of the boss 150 through the coupling hole 145 of the printed circuit board 140. In this embodiment, the bolt 170 includes a head portion 171 having a greater diameter than the coupling hole 145 of the printed circuit board 140, and a screw portion 172 that has an outer diameter which corresponds to the inner diameter of the second screw recess 152, extends from the head portion 171. In one embodiment, the screw portion 172 may be formed only on a portion of the body of the bolt 170 which is substantially the same as the second screw recess 152 in length as shown in Figures 5 and 6. In another embodiment, the screw portion may be formed over the entire body of the bolt 170 such as the screw portion 162 but having the diameter of the screw portion 172 (not shown). In one embodiment, as shown in FIG. 6, a lower end of the screw portion 172 may be separated a predetermined distance from the bottom of the second screw recess 152 when the bolt 170 is completely bolted into the boss 150 so that the head portion 171 can be adhered around the coupling hole 145 of the printed circuit board 140. In another embodiment, a lower end of the screw portion 172 may be aligned with the lower end of the second screw recess 152 (i.e., no predetermined distance existing) when the bolt 170 is completely bolted into the boss 150.

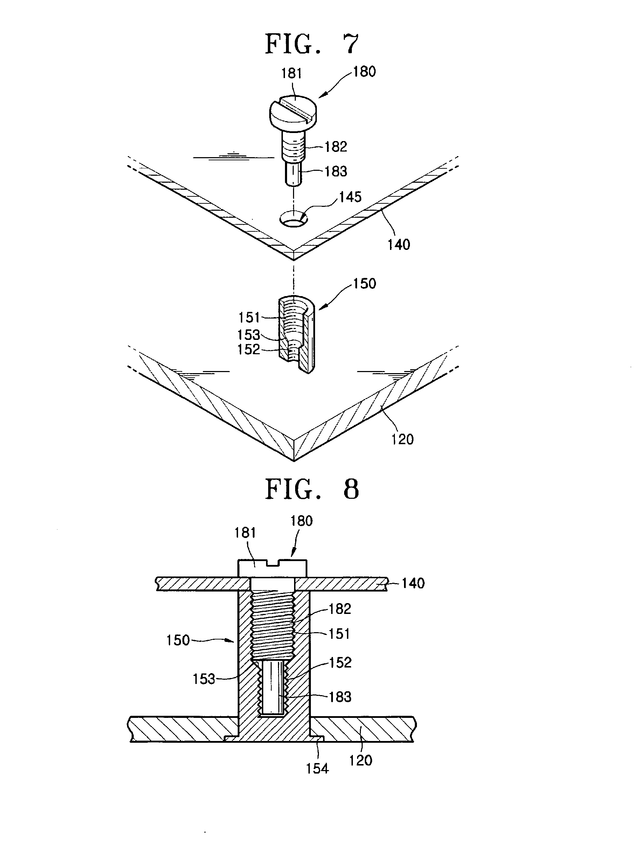

In one embodiment, a bolt 180 illustrated in FIGS. 7 and 8 can be coupled to the boss 150. The bolt 180 includes a head portion 181 having a greater diameter than the coupling hole 145 of the printed circuit board 140, a screw portion 182 that has an outer diameter equal to the inner diameter of the first screw recess 151, extends from the head portion 181, and a guide portion 183 that extends from the screw portion 182 and is inserted into the second screw recess 152. The guide portion 183 guides the bolt 180 to be precisely coupled to the boss 150, and ensures that the bolt 180 is sufficiently supported by the boss 150. In one embodiment, as show in FIG. 8, a lower end of the guide portion 183 may be separated a predetermined distance from the bottom of the second screw recess 152 when the bolt 180 is completely bolted into the boss 150 so that the head portion 181 can be adhered around the coupling hole 145 of the printed circuit board 140. Again, in another embodiment, a lower end of the guide portion 183 may touch the bottom of the inner hole of the boss 150 (i.e., no predetermined distance existing) when the bolt 180 is completely bolted into the boss 150. Alternatively, the guide portion 183 may have an outer diameter equal to the inner diameter of the second screw recess 152 and a screw formed around the circumference of the guide portion 183 so as to be coupled with the second screw recess 152 such that a coupling force between the bolt 180 and the boss 150 can be increased.

According to embodiments of the present invention, the bosses formed in the chassis base have a common structure so that various kinds of bolts can be used and coupled with the bosses. Therefore, it may not be necessary to fabricate different size bosses according to the bolt sizes to be used. Accordingly, overall fabrication and assembly costs associated with the bosses can be reduced.

While the above description has pointed out novel features of the invention as applied to various embodiments, the skilled person will understand that various substitutions, and changes may be made without departing from the scope of the invention. Therefore, the scope of the invention is defined by the appended claims rather than by the foregoing description.

## Claims

1. A plasma display apparatus (100), comprising:
a boss (150) located on a chassis base configured to couple at least one printed circuit board to the chassis base, wherein the boss defines a hole configured to receive a bolt (160), wherein at least two threaded recesses (151, 152) having different diameters are defined inside the hole of the boss, and wherein the at least two threaded recesses are configured to receive either of at least two bolts having different diameters.

2. The apparatus of claim 1, wherein the boss includes first and second threaded recesses (151, 152) that are axially aligned and stacked atop each other with respect to the entrance of the hole, and wherein the second threaded recess (152) has a smaller inner diameter than that of the first threaded recess (151).

3. The apparatus of claim 2, wherein the boss further comprises a frustoconical connection portion (153) between the first threaded recess and the second threaded recess.

4. The apparatus of claim 2, comprising a bolt inserted into at least one of the first and second threaded recesses wherein the bolt includes a head portion (160), and a screw portion (162) extending from the head portion.

5. The apparatus of claim 4, wherein the bolt includes a head portion, a screw portion extending from the head portion and configured to be inserted into the first threaded recess, and a guide portion (183) extending from the screw portion and configured to be inserted into the second threaded recess.

6. The apparatus of claim 1, wherein the boss is integrally formed with the chassis base.

7. The apparatus of claim 2, wherein the boss includes first, second and third threaded recesses that are axially aligned and stacked atop each other with respect to the entrance of the hole, and wherein the third threaded recess has a smaller inner diameter than that of the second threaded recess which is smaller than the first threaded recess in diameter.

## Patentansprüche

1. Eine Plasmaanzeigevorrichtung (100), umfassend:
einen auf einer Chassisgrundplatte angeordneten Vorsprung (150), der derart konfiguriert ist, dass er mindestens eine Leiterplatte mit der Chassisgrundplatte verbindet, wobei der Vorsprung ein Loch definiert, das dazu konfiguriert ist, einen Bolzen (160) aufzunehmen, wobei mindestens zwei Aussparungen mit Gewinde (151, 152) mit unterschiedlichen Durchmessern innerhalb des Lochs des Vorsprungs definiert sind und wobei die mindestens zwei Aussparungen mit Gewinde dazu konfiguriert sind, jeden von mindestens zwei Bolzen mit unterschiedlichen Durchmessern aufzunehmen.

2. Die Vorrichtung nach Anspruch 1, wobei der Vorsprung erste und zweite Aussparungen mit Gewinde (151, 152) beinhaltet, die axial ausgerichtet sind und bezüglich des Eingangs des Lochs aufeinander gestapelt sind, und wobei die zweite Aussparung mit Gewinde (152) einen kleineren Innendurchmesser als die erste Aussparung mit Gewinde (151) aufweist.

3. Die Vorrichtung nach Anspruch 2, wobei der Vorsprung ferner zwischen der ersten Aussparung mit Gewinde und der zweiten Aussparung mit Gewinde einen kegelstumpfförmigen Verbindungsteil (153) umfasst.

4. Die Vorrichtung nach Anspruch 2, umfassend einen in mindestens eine der ersten und zweiten Aussparungen mit Gewinde eingeführten Bolzen, wobei der Bolzen einen Kopfteil (160) sowie einen Schraubteil (162), der sich von dem Kopfteil erstreckt, umfasst.

5. Die Vorrichtung nach Anspruch 4, wobei der Bolzen einen Kopfteil, einen Schraubteil, der sich von dem Kopfteil erstreckt und zur Einführung in die erste Aussparung mit Gewinde konfiguriert ist, sowie einen Führungsteil (183), der sich von dem Schraubteil erstreckt und zur Einführung in die zweite Aussparung mit Gewinde konfiguriert ist, beinhaltet.

6. Die Vorrichtung nach Anspruch 1, wobei der Vorsprung einstückig mit der Chassisgrundplatte ausgebildet ist.

7. Die Vorrichtung nach Anspruch 2, wobei der Vorsprung erste, zweite und dritte Aussparungen mit Gewinde beinhaltet, die axial ausgerichtet sind und bezüglich des Eingangs des Lochs aufeinander gestapelt sind, und wobei die dritte Aussparung mit Gewinde einen kleineren Innendurchmesser als die zweite Aussparung mit Gewinde aufweist, die im Durchmesser kleiner als die erste Aussparung mit Gewinde ist.

## Revendications

1. Appareil d'affichage à plasma (100), comprenant :
un bossage (150) situé sur un châssis de base configuré pour relier au moins une carte de circuit imprimé au châssis de base, le bossage définissant un trou configuré pour recevoir un boulon (160), dans lequel au moins deux évidements filetés (151, 152) ayant des diamètres différents sont définis à l'intérieur du trou du bossage, et dans lequel les au moins deux évidements filetés sont configurés pour recevoir l'un ou l'autre d'au moins deux boulons de diamètres différents.

2. Appareil selon la revendication 1, dans lequel le bossage comprend des premier et deuxième évidements filetés (151, 152) qui sont alignés axialement et empilés l'un sur l'autre par rapport à l'entrée du trou, et dans lequel le deuxième évidement fileté (152) a un diamètre intérieur inférieur à celui du premier évidement fileté (151).

3. Appareil selon la revendication 2, dans lequel le bossage comprend en outre une partie de raccordement tronconique (153) entre le premier évidement fileté et le deuxième évidement fileté.

4. Appareil selon la revendication 2, comprenant un boulon inséré dans au moins l'un des premier et deuxième évidements filetés, le boulon comprenant une partie tête (160) et une partie vis (162) s'étendant depuis la partie tête.

5. Appareil selon la revendication 4, dans lequel le boulon comprend une partie tête, une partie vis s'étendant depuis la partie tête et configurée pour être insérée dans le premier évidement fileté, et une partie guide (183) s'étendant depuis la partie vis et configurée pour être insérée à l'intérieur du deuxième évidement fileté.

6. Appareil selon la revendication 1, dans lequel le bossage est formé de façon solidaire du châssis de base.

7. Appareil selon la revendication 2, dans lequel le bossage comprend des premier, deuxième et troisième évidements filetés qui sont alignés axialement et empilés les uns sur les autres par rapport à l'entrée du trou, et dans lequel le troisième évidement fileté a un diamètre intérieur inférieur à celui du deuxième évidement fileté dont le diamètre est inférieur à celui du premier évidement fileté.
